# EUROPÄISCHE PATENTSCHRIFT

(11) **EP 1 018 031 B1**
(45) Veröffentlichungstag und Bekanntmachung des Hinweises auf die Patenterteilung: **09.10.2002**
(21) Anmeldenummer: 98954273.3
(22) Anmeldetag: 11.09.1998
(51) Int. Cl.: G01R 31/302, G01R 29/08

(54) **VORRICHTUNG ZUM TESTEN VON SCHALTUNGSPLATINEN**
DEVICE FOR TESTING CIRCUIT BOARDS
DISPOSITIF POUR TESTER DES CARTES DE CIRCUITS

(30) Priorität: 24.09.1997 DE 19742055
(43) Veröffentlichungstag der Anmeldung: 12.07.2000
(73) Patentinhaber: Scorpion Technologies AG, 22453 Hamburg (DE)
(72) Erfinder: BUKS, Manfred, D-24558 Henstedt-Ulzburg (DE); HOSSEINI, Karim, D-22299 Hamburg (DE)
(74) Vertreter: Schaefer, Konrad, Dipl.-Phys.
(86) Internationale Anmeldenummer: EP9805801
(87) Internationale Veröffentlichungsnummer: WO99015910

(56) Entgegenhaltungen:
- EP-A- 0 527 321
- GB-A- 2 236 593
- US-A- 4 588 993
- US-A- 5 218 294
- US-A- 5 406 209

## Beschreibung

Die Erfindung betrifft eine Vorrichtung der im Oberbegriff des Anspruchs 1 genannten Art.

Eine nicht gattungsgemäße Vorrichtung ist aus der US-PS 5,254,953 bekannt. Dabei dienen die erste Elektrode und das zu testende Bauelement als Platten eines Kondensators, dessen Kapazität mit der Vorrichtung durch Ladungsänderung auf dem Kondensator bestimmt wird. Dazu muß der Meßverstärker eine Strommessung ausführen, und zwar in einer Verbindungsleitung zwischen der ersten Elektrode und der zweiten Elektrode, als die bei der bekannten gattungsgemäßen Vorrichtung die Masse der zu testenden Schaltung auf einer Platine dient. Die Meßvorrichtung ist also galvanisch mit der Schaltung verbunden.

Mit dieser Vorrichtung können Bauelemente z.B. mit einer elektrischen Schaltung bestückte Platinen auf korrekte Bestückung überprüft werden. Ist das zu testende Bauelement z.B. durch mangelnde Verlötung oder Leitungsunterbrechung nicht ordnungsgemäß kontaktiert, so wird nur die wesentlich kleinere Kapazität gegenüber weiter entfernten Bauelementen, z.B. der Zuführungsleitung, jenseits der Unterbrechung bestimmt.

Vorteilhaft bei gattungsgemäßen Vorrichtungen ist die nicht erforderliche galvanische, also mechanische Kontaktierung zwischen der ersten Elektrode und dem Bauelement. Es sind keine gut leitenden Kontaktflächen auf dem Bauelement erforderlich. Oxydschichten stören z.B. nicht. Auch kann durch Isolierschichten oder nicht leitende Gehäuse hindurch gemessen werden.

Da der Meßabstand in die gemessene Kapazität eingeht, können bei exakter Positionierung der ersten Elektrode geometrische Abweichungen des zu testenden Bauelementes bestimmt werden, z.B. durch Verbiegen, schiefe Bestückung oder dergleichen. Es können auch Steckkontakte gemessen werden, die nur für einmalige Kontaktierung ausgelegt sind und daher nicht z.B. mit einem Teststecker mechanisch belastet werden dürfen.

Nachteilig bei der bekannten Vorrichtung ist das kapazitive Meßverfahren, das zur Ladungsverschiebung auf dem Kondensator Stromfluß in der Schaltung voraussetzt. Dieser Strom fließt bei komplizierteren Schaltungen regelmäßig auch durch andere Bauelemente, deren mögliche Fehlerabweichungen in das Meßergebnis eingehen. Da der Meßverstärker den Strom gegen die Schaltungsmasse bestimmt, liegt außerdem immer eine Kapazität zwischen der ersten Elektrode und der Schaltungsmasse parallel zur Meßkapazität. Diese störende Parallelkapazität ist aber regelmäßig größer als die Meßkapazität, so daß Abweichungen in der parallelen Kapazität gegen Masse größere Abweichungen hervorrufen. Außerdem ist eine große Meßempfindlichkeit erforderlich, um die kleinen Abweichungen der Meßkapazität in der großen Gesamtkapazität (Meßkapazität + viel größere Kapazität gegen Masse) bestimmen zu können.

Eine weitere, nicht gattungsgemäße Testvorrichtung ist aus der
DE 26 39 831 A1
bekannt. Bei dieser bekannten Vorrichtung wird in gattungsgemäßer Weise das bei elektrischer Beaufschlagung mittels einer Stimuliereinrichtung vom Bauelement erzeugte Feld mit einer Feldsonde ausgemessen. Als Feldsonde dient bei dieser bekannten Konstruktion eine Spule, die ausschließlich auf die magnetische Feldkomponente des vom Bauelement erzeugten elektromagnetischen Feldes anspricht. Magnetische Felder werden aber nur bei Stromfluß im Bauelement erzeugt. Folglich muß die Stimuliereinrichtung so ausgebildet sein, daß im Bauelement ein Stromfluß erzeugt wird. Damit ergeben sich wieder ähnliche Nachteile wie bei der zuvor beschriebenen kapazitiven Meßmethode. Alle benachbarten, ebenfalls stromdurchflossenen Bauelemente einer bestückten Schaltung können z.B. stören. Bauelemente, die aus bestimmten Gründen nicht korrekt angeschlossen und somit nicht von Strom durchflossen werden können, können überhaupt nicht getestet werden. Ferner ist durch die bauartbedingte Größe der Spule die örtliche Auflösung des Testverfahrens begrenzt.

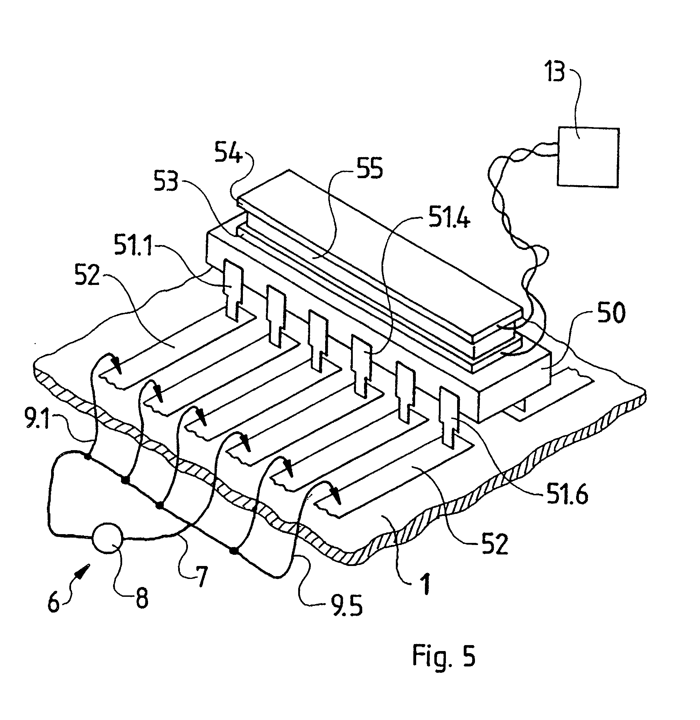

Eine gattungsgemäße Testvorrichtung ist aus US-A-5 218 294 bekannt. Gemäß der in Spalte 2, Zeile 38 erwähnten Alternative "monopole antennas" wird hier das von einem Bauelement bei Stimulus-Beaufschlagung erzeugte elektrische Feld in der Nähe des Bauelementes mit einer Elektrode bestimmt. Im wesentlichen beschreibt diese Schrift jedoch die Bestimmung des elektromagnetischen Feldes mit einer die magnetische Feldkomponente bestimmenden induktiven Antenne, wie sie in Figur 5 dargestellt ist. Es sollen dabei, wie in Spalte 1, Zeile 67 angegeben, die Qualität, Form und Abmessung von Bauteilkomponenten ermittelt werden.

Vorteilhaft dabei ist die kontaktlose Meßmethode, bei der das Bauelement nicht mit Sondenspitzen kontaktiert werden muß. Nachteilig bei dieser Konstruktion ist jedoch das in den Spalten 4 bis 6 der Schrift beschriebene äußerst aufwendige Auswertverfahren, um aus den gemessenen Signalen verwertbare Aussagen zu erhalten. Es sind Spektrumanalysatoren erforderlich und es müssen spezielle Freequenzbandbänder untersucht werden und spektrale Dichten analysiert bzw. Phasenverschiebungen untersucht werden. Das Stimulussignal muß dazu bestimmte Signalmuster aufweisen, deren Wiedererkennung im empfangenen Signal verwendet wird, um verwertbare Aussagen zu erhalten.

Eine ähnliche Konstruktion beschreibt die US-A-5 406 209, bei der Drahtelektroden in der Nähe des Bauelementes angeordnet werden. Auch hier wird das Bauelement mit bestimmten Signalformen beaufschlagt und es werden die empfangenen Signale mit Signalanalysatoren ausgewertet. Auch hier wird also mit Signalformerkennung gearbeitet, um verwertbare Aussagen zu erhalten.

Bei den beiden letztgenannten bekannten Konstruktionen liefert die einfache Bestimmung der Signalintensität keine Ergebnisse, an denen aussagekräftig über Fehler auf dem Bauelement entschieden werden kann. Nur die diskutierten hochkomplexen Auswertalgorithmen führen zu entscheidungskräftigen Werten.

Aus der nicht gattungsgemäßen US-A-4-588993 ist eine Vorrichtung zur Bestimmung von Störfeldern in der Umgebung elektrischer Geräte bekannt. Mit einer aus drei elektrischen (Dipol) und drei magnetischen (Schleife) Antennen gebildeten Sondenanordnung werden an einem Raumpunkt das elektrische und das magnetische Feld nach Betrag und Raumwinkel vermessen. Diese Anordnung dient zum einen völlig anderen Zwecken und ist zum anderen schon auf Grund der erforderlichen Sondengröße zur millimetergenauen Ausmessung des Feldes in enger Nachbarschaft von Bauelementen ungeeignet.

Die Aufgabe der vorliegenden Erfindung besteht darin, eine gattungsgemäße Vorrichtung mit größerer Nachweisempfindlichkeit von Abweichungen am zu testenden Bauelement und mit verringerten Anforderungen an die Auswertmethode zu schaffen.

Diese Aufgabe wird erfindungsgemäß mit den Merkmalen des Anspruches 1 gelöst.

Bei der erfindungsgemäßen Vorrichtung wird mit den beiden Elektroden eine Spannung zwischen zwei Punkten in dem elektrischen Feld bestimmt, das von dem spannungsbeaufschlagten Bauelement erzeugt wird. Die beiden Elektroden sind an einen Meßverstärker der Meßeinrichtung angeschlossen, welche vom Bauelement und somit insbesondere auch von der mit diesem galvanisch kontaktierten Stimuliereinrichtung galvanisch getrennt ist. Daher ergibt eine einfache Spannungsmessung der Felddifferenzspannung zwischen den Elektroden einen hochgenauen Wert, der eine genaue Wiedergabe der Feldgeometrie ist und somit eine exakte Aussage über Geometrie und Anordnung des benachbarten Bauelementes ermöglicht. Durch die galvanische Trennung der Meßeinrichtung werden Beeinflussungen durch das Bauelement vermieden. Es können bei z.B. dicht benachbarten Elektroden kleinste Felddifferenzen mit einem geeigneten Meßverstärker mit hoher Aussagekraft gemessen werden. Eine einzige Spannungsmessung (Gleichspannung oder Wechselspannung) reicht für die Bestimmung eines Meßpunktes aus. Anschließende hochkomplexe Signalauswertungen bei Verwertung entsprechender Stimulussignale, wie nach dem Stand der Technik, können entfallen. Die Erzeugung eines magnetischen Feldes und somit Stromfluß im Bauelement ist nicht erforderlich. Es reicht daher aus, das Bauelement bzw. eine mit Bauelementen besetzte Schaltung mit nur einem Leiter zu kontaktieren. Es kann eine Gleichspannung und somit ein erzeugtes rein elektrostatisches Feld verwendet werden. Die beiden Elektroden bilden eine Feldsonde, mit der die Feldgeometrie um das Bauelement hochgenau ausgemessen werden kann. Dazu können beide Elektroden oder vorzugsweise eine dem Bauelement benachbarte Elektrode bewegt werden. Nahe dem zu testenden Bauelement hängt das Feld im wesentlichen nur von diesem ab. Ist das Bauelement z.B. durch mangelnde Verlötung oder Leitungsunterbrechung nicht an die Stimulusspannung angeschlossen, so ergeben sich starke Feldabweichungen, die gegenüber dem Sollzustand - z.B. ermittelt durch eine vorherige Messung an einer korrekt arbeitenden Platine - sehr einfach nachweisbar sind. Formabweichungen am zu testenden Bauelement, z.B. Schieflage, Verbiegung etc., können durch die sich ergebenden Feldabweichungen sehr einfach detektiert werden. Andere Bauelemente stören wenig aufgrund ihrer geometrisch entfernten, das Feld wenig beeinflussenden Lage, insbesondere, wenn im Nahfeld um das zu testende Bauelement gemessen wird. Der Meßprozeß erzeugt nicht notwendigerweise Ströme in der Schaltung und dadurch bedingte Meßfehler. Wie beim gattungsgemäßen Stand der Technik entfällt jede Kontaktierung der Schaltung durch die Elektroden. Es sind keine gut kontaktierbaren Oberflächen nötig. Es kann über isolierten Oberflächen oder durch Kunststoffgehäuse hindurch gemessen werden, z.B. im Inneren eines in ein Kunststoffgehäuse eingebetteten ICs. Da Feldunsymmetrien besonders gut erkannt werden, löst sich sehr einfach das bisher ungelöste Problem der Erkennung falsch herum eingesetzter Elektrolytkondensatoren. Die Stimuliereinrichtung kann gesonderte Spannungen am Bauelement anlegen, z.B. Gleichspannungen, mit denen Probleme durch Kondensatoren in der Schaltung vermeidbar sind. Es sind auch Impulse, z.B. Wechselspannungen beliebiger Frequenz, verwendbar. Es kann sogar das elektrische Feld bestimmt werden, das sich über Bauelementen beim bestimmungsgemäßen Betrieb der Schaltung ergibt. Daher läßt sich die erfindungsgemäße Vorrichtung auch als Funktionstester einsetzen. Besitzt die erfindungsgemäße Feldsonde eine geeignete geometrische Auflösung, so keimen dabei sogar die Schaltprozesse im Inneren eines ICs betrachtet werden.

Die zweite Elektrode kann irgendwo im elektrischen Feld, z.B. weit außerhalb des Meßortes, angeordnet sein. Dann braucht nur die erste Elektrode von Meßort zu Meßort verfahren zu werden. Vorteilhaft sind jedoch die Merkmale des Anspruches 2 vorgesehen. Sind beide Elektroden dem zu testenden Bauelement benachbart, so wird das elektrische Feld im Nahbereich, in dem sehr hohe Feldstärkedifferenzen vorliegen, sehr präzise ausgemessen, ohne Beeinflussungen durch Felder anderer Bauelemente.

Dabei kann in sehr einfacher Bauform die Feldsonde als Anordnung am Ende eines abgeschirmten Kabels gemäß Anspruch 3 ausgebildet sein. Es lassen sich dadurch Feldmessungen in geometrischer Auflösung bis unter 1 mm durchführen.

Vorteilhaft sind die Merkmale des Anspruches 4 vorgesehen. Dadurch kann bei Messungen im Nahbereich von zu testenden Bauelementen galvanischer Kontakt mit diesen auch bei Positionierabweichungen vermieden werden, die zu störendem galvanischen Kontakt mit der Schaltung führen würden.

Gemäß Anspruch 5 kann vorteilhaft die erste Elektrode auch mehrere Bauelemente gleichzeitig erfassen. Bei geeigneter Stimulierung z.B. der einzelnen Bauelemente nacheinander, wobei die jeweils anderen Bauelemente, z.B. mit der Stimuliereinrichtung geerdet sind, kann mit nur einer Positionierung der ersten Elektrode eine größere Anzahl von Bauelementen gemessen werden. Dies ist insbesondere bei geometrisch und elektrisch im wesentlichen gleichen Bauelementen von Vorteil, wie z.B. bei Kontaktstiften eines Steckers oder bei den Anschlußpins eines ICs.

Die Stimmuliereinrichtung kann eine Gleichspannung anlegen, deren elektrostatisches Feld von der erfindungsgemäßen Vorrichtung präzise ausmeßbar ist. Vorteilhaft wird jedoch gemäß Anspruch 6 eine gepulste Spannung angelegt, z.B. eine gepulste Gleichspannung oder eine Wechselspannung, die von dem Meßverstärker besser nachweisbar ist.

Vorteilhaft sind dabei gemäß Anspruch 7 Pulsfolgen niedriger Frequenz verwendet, die außerhalb des üblichen Frequenzbereiches liegen, in dem benachbarte Meßeinrichtungen und Computer abstrahlen.

Vorzugsweise wird dabei gemäß Anspruch 8 als Pulsform eine Dreieckform verwendet. Diese hat den Vorzug, daß sie an Kapazitäten der Meßanordnung zu Rechtecken differenziert wird, welche vom Meßverstärker besser verarbeitbar sind.

Vorzugsweise unterdrückt der Meßverstärker gemäß Anspruch 9 Gleichspannung. Elektrostatische Felder, wie sie z.B. durch elektrostatische Aufladung in der Nähe des Meßortes entstehen können und die zu Fehlmessungen führen können, werden dadurch unterdrückt.

Vorzugsweise ist der Meßverstärker gemäß Anspruch 10 derart ausgebildet, daß er vorkommende Störfrequenzen unterdrückt, wie z.B. Netzfrequenzen im 50 Hertzbereich, die von benachbarten Netzgeräten erzeugt werden oder sonstige störende Frequenzen, die in der Nähe des Meßortes abgestrahlt werden, z.B. durch Computer-CPUs im 100 Megahertzbereich, von Robotersteuermotoren und dergleichen.

Vorzugsweise sind die Merkmale des Anspruches 11 vorgesehen. Wie auch von anderen Sende- und Empfangseinrichtungen her bekannt, lassen sich auf diese Weise Störungen aus der Umgebung besonders gut unterdrücken.

Vorzugsweise sind die Merkmale des Anspruches 12 vorgesehen. Hierbei wird das elektrische Feld in der Nähe eines oder mehrerer Bauelemente, z.B. über einer bestückten Platine, durch Verfahren der Elektrode in seiner geometrischen Anordnung ausgemessen.

Alternativ sind vorteilhaft die Merkmale des Anspruches 13 vorgesehen. Es sind dort als erste Elektrode Matrixelektroden in größerer Zahl, z.B. flächig parallel zu einer zu testenden Platine angeordnet, die mit einer geeigneten Einrichtung nacheinander mit dem Meßverstärker verbunden sind und auf diese Weise mit einem statischen, nicht bewegten Aufbau eine geometrische Auflösung des vom Bauelement erzeugten Feldes ermöglichen.

Dabei sind vorteilhaft die Merkmale des Anspruches 14 vorgesehen. Mit solchen Zeilen- und Spaltenelektroden, die jeweils zu zweit gekreuzt mit dem Meßverstärker verbunden werden, wozu eine übliche Multiplexansteuerung verwendbar ist, läßt sich eine flächige Auflösung des Feldes erreichen, da bei Verbindung zweier Elektroden des Matrixfeldes nur diese zur Zeit empfindlich sind, und zwar mit höchster Empfindlichkeit an ihrem Kreuzungspunkt, so daß dieser eine Aussage über die dortige Feldstärke macht. Durch Multiplexansteuerung aller Zeilenund Spaltenelektroden nacheinander lassen sich die Feldstärken an allen Kreuzungspunkten bestimmen.

In den Zeichnungen ist die Erfindung beispielsweise und schematisch dargestellt.
Es zeigen:
- Fig. 1a und 1b:: den Test eines Kontaktstiftes auf ordnungsemäße Verlötung mit einer Leiterbahn,
- Fig. 2a und 2b:: den Test zweier parallelen Leiterbahnen auf Unterbrechung einer der Leiterbahnen,
- Fig. 3a und 3b:: den Test eines Elektrolytkondensators auf korrekte Einbaulage,
- Fig. 4:: eine erfindungsgemäße Feldsonde in Ausbildung am Ende einer abgeschirmten Leitung mit Positioniereinrichtung,
- Fig. 5:: eine erfindungsgemäße Feldsonde zum Testen aller Pins eines ICs in nur einer Positionierstellung,
- Fig. 6: eine Draufsicht auf eine Ausführungsform der erfindungsgemäßen Feldsonde mit einer Matrixanordnung von Elektroden und
- Fig. 7: eine Draufsicht auf eine Variante zur Ausführungsform der Fig. 6 mit gekreuzten Matrixelektroden.

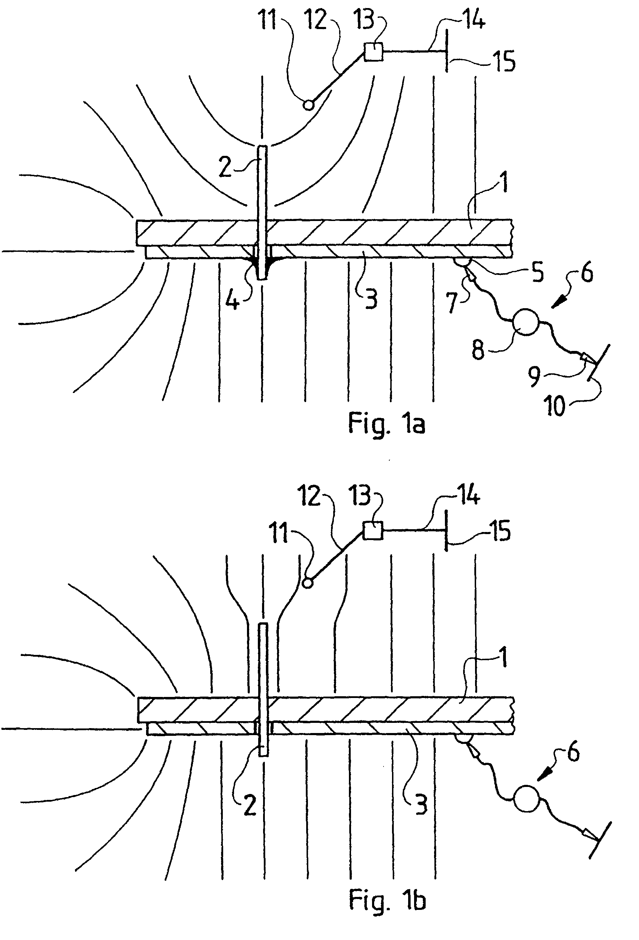

Fig. 1a zeigt im Schnitt eine typische Testsituation auf einer nichtleitenden Platine 1, auf der ein Metallstift 2, z.B. einer von mehreren Stiften einer Steckkontaktleiste befestigt ist, der mit einer Leiterbahn 3 auf der Platine durch eine Lötstelle 4 kontaktiert ist.

An die Leiterbahn 3 wird an einer geeigneten Kontaktstelle 5 mit einer Stimuliereinrichtung 6 eine Spannung, z.B. eine Gleichspannung von einigen Volt, angelegt, und zwar mit einer Kontaktspitze 7, die an eine Spannungsquelle 8 angeschlossen ist. Mit der zweiten Kontaktspitze 9 der Spannungsquelle 8 ist ein Leiter 10 kontaktiert, der im Abstand zur Leiterbahn 3 liegt. Bei dem Leiter 10 kann es sich um Erde, Masse der auf der Platine 1 befindlichen Schaltung oder auch um eine Feldplatte handeln, die irgendwo frei im Raum aufgehängt ist.

Zwischen dem Leiter 10 und der Leiterbahn 3 sowie den damit elektrisch verbundenen Elementen, wie insbesondere dem zu testenden Bauelement in Form des Stiftes 2, bildet sich im umgebenden Raum ein elektrisches Feld aus. Ist der Leiter 10 von den Bauelementen 2 und 3 weit entfernt, so bildet sich um letztere ein im wesentlichen ungestörtes elektrisches Feld aus, dessen Feld(kraft)linien etwa so aussehen, wie in Fig. 1a dargestellt.

Man sieht, daß die Feldlinien stets senkrecht zu den Leitern 2, 3 stehen. An den Leiterenden, also an Spitzen der Leiter, verlaufen die Linien divergent. An langgestreckten Leitungsstücken verlaufen sie im wesentlichen parallel zueinander.

Fig. 1b zeigt dieselbe Anordnung, jedoch bei fehlender Verlötung 4. Der Stift 2 ist hier gegenüber der Leiterbahn 3 elektrisch isoliert. Die von der Stimuliereinrichtung 6 an die Leiterbahn 3 angelegte Spannung liegt nicht am Stift 2 an. Der Stift 2 liegt also nur als Leiter frei im elektrischen Feld. Er beeinflußt das Feld durch Influenz, also Ladungsverschiebungen auf dem Stift 2 geringfügig. Es ergibt sich dadurch, wie dargestellt, eine völlig andere Ausbildung der Feldlinien im Bereich des Stiftes 2. Insbesondere fehlt die starke Divergenz im Bereich der oberen Spitze des Stiftes 2.

Wird eine Feldsonde mit einer Elektrode 11, wie dargestellt, in den Fällen der Figuren 1a und 1b in gleicher geometrischer Anordnung benachbart zum Stift 2 angeordnet, so sieht sie in den beiden dargestellten Fällen der Figuren 1a und 1b völlig unterschiedliche Feldstärken. Damit kann der dargestellte Fehler (fehlende Lötstelle 4) nachgewiesen werden. Liegen andere Fehler vor, wie beispielsweise ein elektrisch isolierender Bruch im Stift 2, z.B. innerhalb der Platine 1, oder z.B. ein Bruch in der Leiterbahn 3, so ergeben sich ähnliche, das elektrische Feld stark verzerrende Effekte, die zu sicherem Nachweis des Fehlers führen.

Da die Geometrie des Meßortes sehr stark in das Meßergebnis eingeht, kann bei exakt reproduzierter räumlicher Positionierung der Feldsonde 11 gegenüber der Platine 1 auch eine geometrische Abweichung des Stiftes 2 nachgewiesen werden, z.B. eine Verbiegung des Stiftes, eine zu geringe Länge oder dergleichen.

Die dargestellte Feldsonde kann mit ihrer Elektrode 11 z.B. als Feldplatte ausgebildet sein, die über eine Leitung 12 mit einem Eingang eines Meßverstärkers 13 verbunden ist. Mit einer zweiten Leitung 14 ist der andere Eingang des Meßverstärkers 13 mit einer zweiten Elektrode in Form einer Feldplatte 15 verbunden, die irgendwo im Raum an anderer Stelle angeordnet ist. Liegen die erste Elektrode 11 und zweite Elektrode 15 weit auseinander, so wird das elektrische Feld im Nahfeld des Stiftes 2 allein durch die Positionierung der ersten Elektrode 11 bestimmt, während die zweite Elektrode 15 vorzugsweise in einem von der Schaltung auf der Platine 1 ungestörten Bereich liegt. Der durch die Elektroden 11 und 15 gebildete Dipol kann jedoch auch sehr kleinräumig, also mit eng benachbarten sehr kleinen Elektroden 11 und 15 ausgebildet sein und bestimmt dann hochpräzise die lokale Feldstärke am Ort der Feldsonde 11. Da ein solcher Dipol richtungsabhängig mißt, also in Richtung der dargestellten Feldlinien eine höhere Empfindlichkeit als quer zu diesen aufweist, läßt sich die Richtung der Feldlinien bestimmen und somit das elektrische Feld sehr genau erfassen.

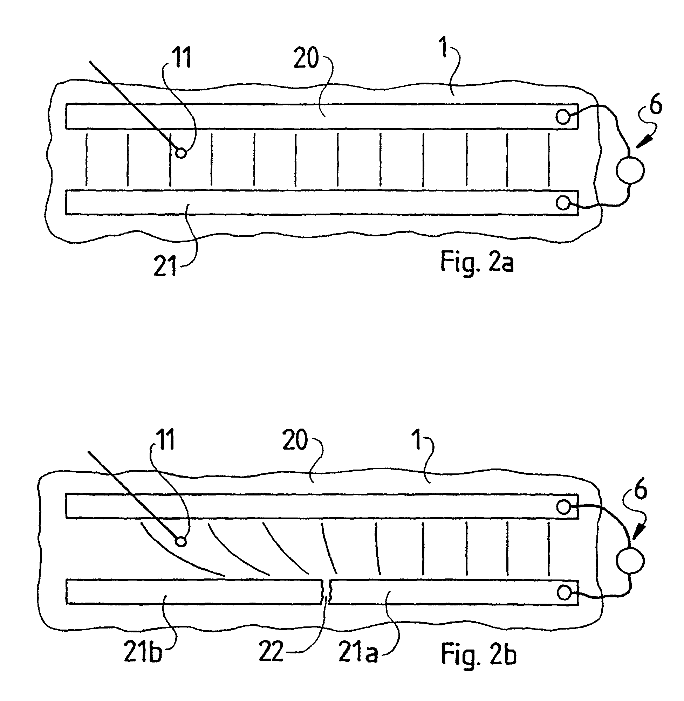

Die Figuren 2a und 2b zeigen ein anderes typisches Meßproblem auf der Platine 1, die diesmal in Draufsicht dargestellt ist. Zwei Leiterbahnen 20 und 21 liegen parallel und sind von der Stimuliereinrichtung 6 mit einer Spannungsdifferenz beaufschlagt. Es bildet sich zwischen ihnen, wie Fig. 2a zeigt, eine elektrisches Feld mit parallelen Feldlinien aus. Dieses kann an der dargestellten Stelle mit der Elektrode 11 der Feldsonde bestimmt werden, die im übrigen der der Fig. 1 entsprechen kann.

In Fig. 2a ist die Leiterbahn 21 mit einer Bruchstelle 22 unterteilt in die beiden Teilstücke 21a und 21b. Nur das Teilstück 21a ist von der Stimuliereinrichtung 6 mit Spannung beaufschlagt, während das abgetrennte Teilstück 21b spannungsfrei ist.

Wie Fig. 2b zeigt, bildet sich dadurch eine starke Veränderung im elektrischen Feld aus, wie die dargestellten Feldlinien anzeigen. Diese starke Abweichung im elektrischen Feld kann von der Feldsonde 11 in Vergleich zur Messung in Fig. 2a an einer ordnungsgemäß gefertigten Platine leicht erkannt werden.

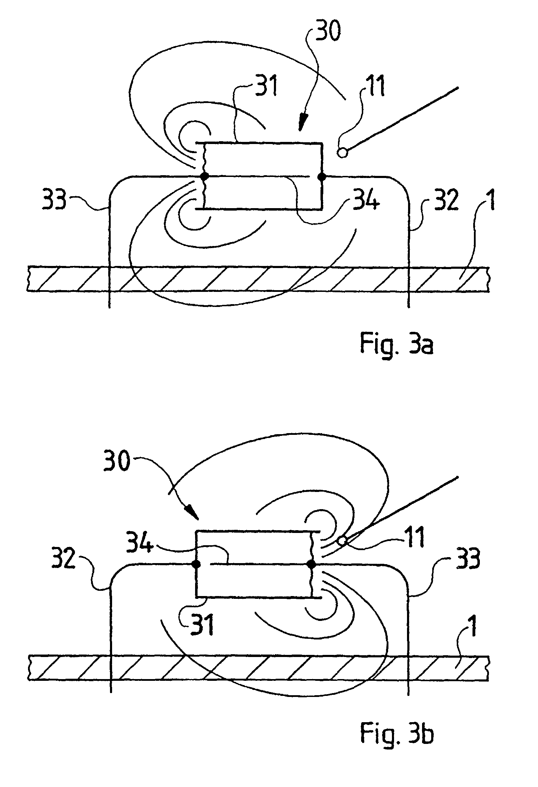

Die Figuren 3a und 3b zeigen einen außerordentlichen schwierigen Testfall auf der Platine 1 (im Schnitt dargestellt), nämlich einen Elektrolytkondensator 30, der zu Erläuterungszwecken stark schematisiert in älterer Bauform dargestellt ist.

Der Elektrolytkondensator 30 weist eine äußere topfförmig das Gehäuse ausbildende Elektrode 31 auf, die mit einer Zuleitung 32 kontaktiert ist sowie eine mit einer Zuleitung 33 kontaktierte innere Elektrode 34.

In Fig. 3a ist der Elektrolytkondensator 30 in korrekter Einbaulage vorgesehen. In Fig. 3b sitzt er falsch herum, also mit umgekehrter Polarität. Dies muß von der Testvorrichtung erkannt werden.

Zum Test wird in beiden Fällen der Kondensator 30 mit Spannung beaufschlagt, und zwar durch Kontaktierung der Zuleitungen 32 und 33 mit einer nicht dargestellten Stimuliereinrichtung, z.B. der Stimuliereinrichtung 6 der Fig. 1. Es ergibt sich dabei in der Umgebung des Elektrolytkondensatoren 30 jeweils ein elektrisches Feld mit Feldlinien, wie sie in Figuren 3a und 3b dargestellt sind. Man erkennt, daß die Feldlinien in dem Bereich des Elektrolytkondensators 30, in dem die Zuleitung 33 mit der inneren Elektrode 34 kontaktiert ist, mit hoher Dichte, also hoher Feldstärke, aus der Öffnung der abschirmenden topfförmigen äußeren Elektrode 31 austreten, im Abstand von dieser Stelle jedoch eine sehr geringere Feldstärke herrscht. Wird in den beiden Fällen der Figuren 3a und 3b die bereits erwähnte Feldsonde 11 in derselben geometrischen Anordnung benachbart zum Elektrolytkondensator 30 angeordnet, so ergibt sich in den beiden dargestellten Fällen der Figuren 3a und 3b eine extrem unterschiedliches Meßergebnis, völlig im Gegensatz zu allen anderen bekannten Testvorrichtungen, die im dargestellten Beispiel eines verkehrt eingebauten Elektrolytkondensators nur sehr geringe Meßergebnisse ergeben. Mehrere Messungen mit vertauschter Stimuluspolarität sind nicht erforderlich.

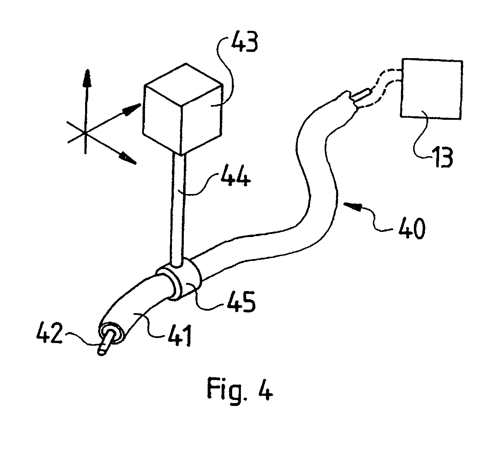

Fig. 4 zeigt ein Beispiel für eine Feldsonde mit einem räumlich sehr kleinen, also die Feldgeometrie hoch auflösenden Dipol. Die Feldsonde ist am Ende eines abgeschirmten Kabels 40 vorgesehen. Dabei werden die beiden Pole des Dipols von der äußeren Abschirmung 41 und dem aus dem Ende des abgeschirmten Kabels 40 heraussragenden Innenleiter 42 gebildet. Wird ein sehr dünnes abgeschirmtes Kabel mit einem Gesamtdurchmesser von unter z.B. 1 mm verwendet, so läßt sich eine Dipolfeldsonde mit einem Abstand der beiden Pole im Bereich unter 1 mm erzeugen, mit der elektrische Felder mit entsprechend kleiner geometrischer Auflösung vermessen werden können.

Fig. 4 zeigt ferner eine Positioniereinrichtung 43, die mit nicht dargestellten Einrichtungen in den dargestellten drei Raumrichtungen verstellbar ist und die mit einem Arm 44 und einer Klammer 45 den Endbereich des abgeschirmten Kabels 40, also die Feldsonde, trägt. Mit der Positioniereinrichtung 43 kann die Feldsonde im elektrischen Feld um Bauelemente genau positioniert werden.

Das abgeschirmte Kabel 40 ist an seinem der Feldsonde abgewandten Ende mit seiner Abschirmung 41 und seinem Innenleiter 42 an die beiden Eingänge des bereits erwähnten Meßverstärkers 13 angeschlossen, der die Spannung zwischen den Elektroden 42 und 41 mitbestimmt, wobei sein Eingang sehr hochohmig sein muß, um das Feld nicht zu sehr zu belasten.

Fig. 5 zeigt in perspektivischer Ansicht einen handelsüblichen IC 50 mit Anschlußpins 51, die in einer Reihe angeordnet sind. Es soll getestet werden, ob die Pins 51.1 - 51.6 ordnungsgemäß mit Leiterbahnen 52 der Platine 1 verlötet sind, wobei die Lötstellen entsprechend den Lötstellen 4 in Fig. 1a ausgebildet sein können.

Zur Zeit soll der Pin 51.4 auf ordnungsgemäße Verlötung getestet werden. Es wird die bereits beschriebene Stimuliereinrichtung 6 angelegt, die mit einer Kontaktspitze 7 die Leiterbahn zum Pin 51.4 kontaktiert und mit ihrem anderen Pol mit einer Reihe paralleler Kontaktspitzen 9.1 - 9.5 alle anderen Leiterbahnen 52 mit dem anderen Pol der Spannungsquelle 8 verbindet. An den Pin 51.4 wird also eine Spannung angelegt gegen alle anderen Pins.

Die Testvorrichtung weist im Ausführungsbeispiel der Fig. 5 zwei Elektroden 53 und 54 auf, die durch eine Isolierung 55 getrennt sind und über verdrillte Zuleitungen an den bereits diskutierten Meßverstärker 13 angeschlossen sind. Wie aus Fig. 5 ersichtlich, erstrecken sich die beiden Elektroden 53 und 54 großflächig über den gesamten IC 50, liegen also allen Pins 51.1 - 51.6 gleichermaßen benachbart. Das durch Anlegen einer Spannung mit der Stimuliereinrichtung 6 an den Pins erzeugte elektrische Feld kann von den Elektroden 53 und 54 erfaßt und mit dem Meßverstärker 13 nachgewiesen werden. Wie die Fig. 5 zeigt, ergibt sich dabei im wesentlichen dasselbe Feld bei unterschiedlicher Beschaltung der Pins. Es kann also jeder der Pins 51.1 - 51.6 nacheinander mit der Kontaktspitze 7 der Stimuliereinrichtung 6 verbunden werden, wobei jeweils alle übrigen Pins mit den Kontaktspitzen 9.1 - 9.5, also dem anderen Ausgang der Spannungsquelle 8, verbunden sind. Auf diese Weise können in derselben Weise, wie zu den Figuren 1a und 1b beschrieben, alle Pins 51.1 - 51.6 nacheinander auf ordnungsgemäße Verlötung mit ihren Leiterbahnen 52 untersucht werden. Die Elektrodenanordnung 53, 54 braucht dabei nicht jeweils neu positioniert zu werden, was den Testablauf wesentlich vereinfacht.

Mit dem Testaufbau gemäß Fig. 5 können auch andere ähnliche Strukturen untersucht werden, z.B. in Reihenanordnung stehende Stifte einer Steckerleiste und dergleichen.

Der in den diskutierten Ausführungsformen beschriebene Meßverstärker 13 muß zur Messung sehr kleiner Feldstärken ausgebildet sein. Er muß also sehr kleine Spannungen, z.B. im µV-Bereich nachweisen können.

Bei der Konstruktion des Meßverstärkers 13 ist zu berücksichtigen, daß am Meßort störende Fremdfelder vorliegen können, die sich dem Feld das von dem zu testenden Bauelement erzeugt wird, überlagern. Solche Felder können z.B. Frequenzen im Netzfrequenzbereich haben, also z.B. von benachbarten Transformatoren stammen. Außerdem können benachbart aufgestellte Computer sehr starke Störungen im Bereich z.B. 100 Megahertz erzeugen. Solche bekannten Störfrequenzen können durch geeignete Filtereinrichtungen im Meßverstärker 13 unterdrückt werden.

Es können aber auch starke Gleichfeldstörungen vorliegen, z.B. durch elektrostatische Felder, die beispielsweise von elektrostatischer Aufladung herrühren. Daher unterdrückt der Meßverstärker 13 vorteilhaft auch Gleichspannung.

Bei Gleichspannungsunterdrückung am Meßverstärker 13 muß das zu messende, vom Bauelement abgestrahlte Feld gepulst sein. Die Stimuliereinrichtung 6 ist dabei zum Anlegen von Impulsen ausgebildet, die in Form von Gleichspannungsimpulsen. Wechselspannungsimpulsen oder auch als sinusförmige Wechselspannung verwendbar sind. Diese haben dann vorzugsweise Frequenzen im unteren Frequenzbereich, also unter z.B. 100.000 Hz, da in diesem niedrigen Frequenzbereich weniger Störfrequenzen auftreten. Vorzugsweise wird die Stimuliereinrichtung 6 mit dem Meßverstärker 13 auf geeignetem Wege synchronisiert, beispielsweise durch Selbstsynchronisation des Meßverstärkers am empfangenen Signal. Dadurch können Störungen durch Fremdfelder weiter unterdrückt werden.

In besonders bevorzugter Ausbildung liefert die Stimuliereinrichtung 6 Dreieckimpulse, die nach Differenzierung an Kapazitäten im Meßaufbau Rechteckimpulse ergeben, welche vom Meßverstärker 13 besonders einfach nachweisbar sind.

Wenn beispielsweise die in Fig. 4 dargestellte Feldsonde, die zur sehr kleinräumigen Ausmessung des elektrischen Feldes geeignet ist, im Nahbereich eines zu testenden Bauelementes, z.B. des Stiftes 2 in Fig. 1a, positioniert wird und das Feld in unmittelbarer Nähe des Bauelementes bestimmt werden soll, kann es bei Fehlpositionierungen zu galvanischem Kontakt der Elektrode 42 mit dem Stift 2 kommen. Dies würde zu Fehlmessungen führen. Daher kann in nicht dargestellter Weise diese Elektrode oder auch beide Elektroden 42 und 41 mit einem Isolierüberzug versehen sein, der die Feldmessung nicht stört, jedoch elektrisch leitenden Kontakt verhindert.

Aus Vorstehendem ergibt sich, daß die erste Elektrode zum Ausmessen des vom Bauelement oder von mehreren Bauelementen erzeugten elektrischen Feldes dieses z.B. gemäß der Ausführungsform der Fig. 5 großflächig bestimmen kann oder z.B. gemäß Ausführungsform der Fig. 4 punktförmig mit einer Bewegungseinrichtung die zum Ausmessen des Feldes die Elektrode durch das Feld bewegt.

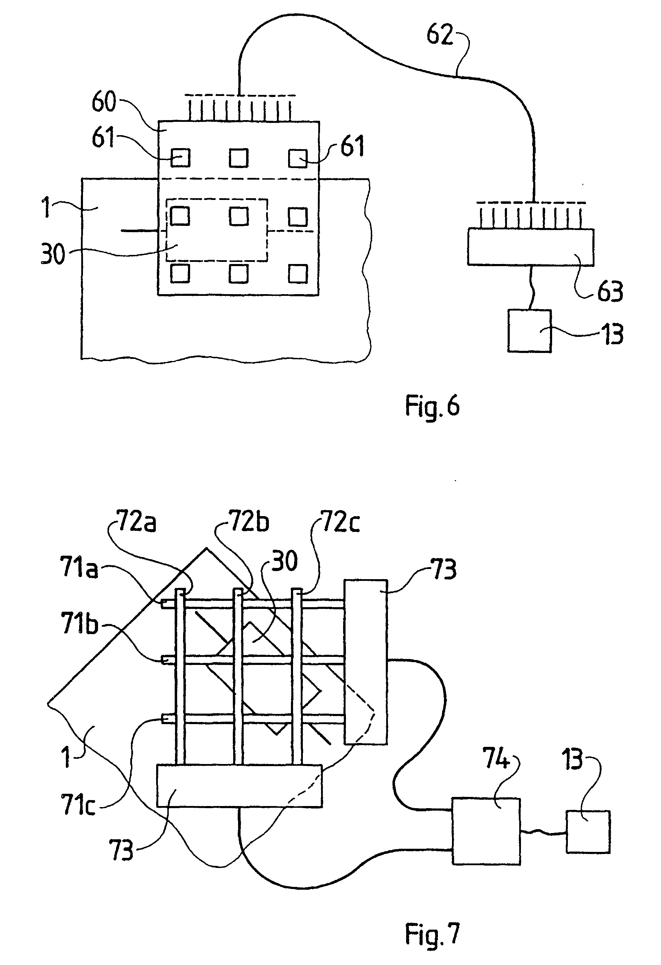

In einer alternativen Ausführungsform gemäß Fig. 6 wird das Feld ebenfalls punktförmig ausgemessen, jedoch mit einer statischen, nicht bewegten Elektrodenanordnung.

Fig. 6 zeigt die Platine 1 mit einem Kondensator 30, in dessen Nähe das elektrische Feld zu bestimmen ist. Dazu ist parallel und benachbart zur Platine über dem Kondensator 30 eine nichtleitende Elektrodenplatte 60 mit auf dieser, im ausführungsbeispiel in einer Rechteckmatrix, angeordneten Elektroden 61 angeordnet. Im Ausführungsbeispiel sind neun Elektroden 61 vorgesehen. Diese sind über neun Leitungen 62 an einen Umschalter 63 angeschlossen, der die Elektroden nacheinander einzeln mit dem Meßverstärker 13 verbindet.

Mit dieser Anordnung kann das Feld in Umgebung des Kondensators 30 nacheinander an den Orten der einzelnen Elektroden 61 bestimmt werden, genauso als wenn man die erste Elektrode 11 gemäß Fig. 3a in der Nähe des Kondensators 30 in dessen Feld auf die Matrixpunkte bewegt.

Fig. 7 zeigt eine Variante der Ausführungsform der Fig. 6, die ebenfalls zur Ausmessung des Feldes um den Kondensator 30 auf der Platine 1 dient.

Bei der Anordnung der Fig. 7 besteht die Elektrodenmatrix aus drei Zeilenelektroden 71 und drei Spaltenelektroden 72, die gekreuzt angeordnet und über Umschalter 73 und 74 mit dem Meßverstärker 13 verbunden sind. Sind z.B. über die Umschalter 73, 74 die beiden Elektroden 71a und 72a an den Meßverstärker angeschlossen, so wird am Kreuzungspunkt dieser beiden Elektroden das Feld bestimmt. Sind z.B. die Elektroden 71c und 72c angeschlossen, so wird an deren Kreuzungspunkt das Feld bestimmt. Auf diese Weise lassen sich die beiden Messungen durchführen, die in den Fig. 3a und 3b dargestellt sind. Wird eine sehr viel größere Anzahl von Zeilen- und Spaltenelektroden verwendet, so läßt sich das Feld über einem sehr großen Schaltungsbereich mit einer Auflösung bestimmen, die vom Abstand der Elektroden abhängt.

Mit den dargestellten Testvorrichtungen können Bauelemente aller Art, wie z.B. einzelne Schalter, Kondensatoren, ICs u. dgl. sowie insbesondere auch unbestückte Platinen getestet werden, letztere insbesondere auf Leiterunterbrechung. Ferner können elektrische Schaltungen mit mehreren Bauelementen, wie z.B. bestückte Platinen, getestet werden.

## Patentansprüche

1. Vorrichtung zum Testen von elektronischen Bauelementen (1, 2, 21, 30, 51.4), mit einer Stimuliereinrichtung (6), die das Bauelement galvanisch kontaktiert und durch Anlegung einer Spannung zum Aufbau eines Feldes im umgebenden Raum anregt, sowie mit einer Meßeinrichtung, die mit einer ersten Elektrode (11; 42; 53; 61; 71. 72) in der Nähe des Bauelementes positioniert ist, **dadurch gekennzeichnet, daß** die Meßeinrichtung (11, 13, 15) von dem Bauelement (1, 2, 21, 30, 51.4) galvanisch getrennt ist und daß die Meßeinrichtung einen Meßverstärker (13) aufweist, der zur Messung einer Spannungsdifferenz zwischen der ersten Elektrode (11; 42; 53; 61; 71. 72) und einer im Abstand zu dieser im Feld angeordneten zweiten Elektroden (15) ausgebildet ist.

2. Vorrichtung nach Anspruch 1, **dadurch gekennzeichnet, daß** die beiden Elektroden (41, 42) zueinander in einem geringen Abstand von der Größenordnung der Struktur des zu testenden Bauelementes angeordnet sind.

3. Vorrichtung nach Anspruch 2, **dadurch gekennzeichnet, daß** eine Elektrode durch die Abschirmung (41) eines abgeschirmten Kabels (40) und die andere Elektrode durch dessen über das Ende des Kabels vorstehenden Innenleiter (42) gebildet ist.

4. Vorrichtung nach Anspruch 1, **dadurch gekennzeichnet, daß** wenigstens die erste Elektrode (11, 42, 53) mit einer galvanischen Kontakt verhindernden Isolierung versehen ist.

5. Vorrichtung nach Anspruch 1, **dadurch gekennzeichnet, daß** die erste Elektrode (53) großflächig mehrere Bauelemente (51.1 - 51.6) überdekkend ausgebildet ist.

6. Vorrichtung nach Anspruch 1, **dadurch gekennzeichnet, daß** die Stimuliereinrichtung (6) eine gepulste Spannung anlegt.

7. Vorrichtung nach Anspruch 6, **dadurch gekennzeichnet, daß** die Pulsfolge einer Frequenz unter etwa 100.000 Hz entspricht.

8. Vorrichtung nach Anspruch 6, **dadurch gekennzeichnet, daß** die Impulse Dreieckform haben.

9. Vorrichtung nach Anspruch 6, **dadurch gekennzeichnet, daß** der Meßverstärker (13) Gleichspannung unterdrückt.

10. Vorrichtung nach Anspruch 6, **dadurch gekennzeichnet, daß** der Meßverstärker (13) Störfrequenzen unterdrückt.

11. Vorrichtung nach Anspruch 6, **dadurch gekennzeichnet, daß** der Meßverstärker (13) mit der Stimuliereinrichtung (6) synchronisiert arbeitet.

12. Vorrichtung nach Anspruch 1, **dadurch gekennzeichnet, daß** die erste Elektrode (11, 42) in der Nähe des Bauelementes (2, 21, 30) verfahrbar angeordnet ist.

13. Vorrichtung nach Anspruch 1, **dadurch gekennzeichnet, daß** die erste Elektrode in Form einer Matrix getrennter, wahlweise an den Meßverstärker (13) anschließbarer Matrixelektroden (61) ausgebildet ist.

14. Vorrichtung nach Anspruch 13, **dadurch gekennzeichnet, daß** die Matrixelektroden als gekreuzt angeordnete Zeilenelektroden (71a - 71c) und Spaltenelektroden (72a - 72c) ausgebildet sind, von denen wahlweise jeweils eine der Zeilenelektroden und eine der Spaltenelektroden gleichzeitig angeschlossen sind.

## Claims

1. Apparatus for testing electronic components (1, 2, 21, 30, 51.4) including a stimulating device (6), which galvanically contacts the component and excites it by applying a voltage to create a field in the surrounding space, and including a measuring device, which is positioned with a first electrode (11; 42; 53; 61; 71.72) in the vicinity of the component, **characterised in that** the measuring device (11, 13, 15) is galvanically isolated from the component (1, 2, 21, 30, 51.4) and that the measuring device has a measuring amplifier (13), which is constructed to measure a voltage differential between the first electrode (11; 42; 53; 61; 71.72) and a second electrode (15), disposed at a distance from it in the field.

2. Apparatus as claimed in Claim 1, **characterised in that** the two electrodes (41, 42) are disposed at a small distance from one another of the order of the structure of the component to be tested.

3. Apparatus as claimed in Claim 2, **characterised in that** one electrode is constituted by the shielding (41) of a shielded cable (40) and the other electrode is constituted by its internal conductor (42) projecting beyond the end of the cable.

4. Apparatus as claimed in Claim 1, **characterised in that** at least the first electrode (11, 42, 53) is provided with insulation preventing galvanic contact.

5. Apparatus as claimed in Claim 1, **characterised in that** the first electrode (53) has a large area covering a plurality of components (51.1 - 51.6).

6. Apparatus as claimed in Claim 1, **characterised in that** the stimulating device (6) applies a pulsed voltage.

7. Apparatus as claimed in Claim 6, **characterised in that** the pulse sequence corresponds to a frequency below about 100,000 Hz.

8. Apparatus as claimed in Claim 6, **characterised in that** the pulses are of triangular shape.

9. Apparatus as claimed in Claim 6, **characterised in that** the measuring amplifier (13) suppresses dc voltages.

10. Apparatus as claimed in Claim 6, **characterised in that** the measuring amplifier (13) suppresses interfering frequencies.

11. Apparatus as claimed in Claim 6, **characterised in that** the measuring amplifier (13) operates in synchronism with the stimulating device (6).

12. Apparatus as claimed in Claim 1, **characterised in that** the first electrode (11, 42) is arranged to be movable in the vicinity of the component (2, 21, 30).

13. Apparatus as claimed in Claim 1, **characterised in that** the first electrode is in the form of a matrix of separate matrix electrodes (61), which are selectively connectable to the measuring amplifier (13).

14. Apparatus as claimed in Claim 13, **characterised in that** the matrix electrodes are constructed in the form of intersectingly arranged line electrodes (71a - 71c) and column electrodes (72a - 72c), of which one of the line electrodes and one of the column electrodes are selectively simultaneously connected.

## Revendications

1. Dispositif pour tester les composants électroniques (1, 2, 21, 30, 51.4), muni d'un système stimulateur (6) qui contacte directement le composant et, par l'application d'une tension, l'active de façon à ce qu'il forme un champ dans l'espace environnant, ainsi que d'un système de mesure positionné à proximité du composant avec une première électrode (11; 42; 53; 61; 71. 72), **caractérisé en ce que** le système de mesure (11, 13, 15) est isolé électriquement du composant (1, 2, 21, 30, 51.4) et **en ce que** le système de mesure présente un amplificateur de mesure (13) conçu en vue de la mesure d'une différence de potentiel entre la première électrode (11; 42; 53; 61; 71. 72) et une seconde électrode (15) positionnée dans le champ à une certaine distance de la première.

2. Dispositif selon la revendication 1, **caractérisé en ce que** les deux électrodes (41, 42) sont agencées à une faible distance l'une de l'autre de l'ordre de grandeur de la structure du composant à tester.

3. Dispositif selon la revendication 2, **caractérisé en ce qu**'une électrode est formée par le blindage (41) d'un câble blindé (40) et l'autre par le conducteur intérieur (42) du câble dépassant de l'extrémité de celui-ci.

4. Dispositif selon la revendication 1, **caractérisé en ce qu**'au moins la première électrode (11, 42, 53) est munie d'une isolation empêchant les contacts électriques directs.

5. Dispositif selon la revendication 1, **caractérisé en ce que** la première électrode (53) est conformée de façon à pouvoir recouvrir plusieurs composants (51.1 - 51.6).

6. Dispositif selon la revendication 1, **caractérisé en ce que** le système stimulateur (6) applique une tension en régime pulsé.

7. Dispositif selon la revendication 6, **caractérisé en ce que** la succession d'impulsions a une cadence correspondant à une fréquence inférieure à environ 100.000 Hz.

8. Dispositif selon la revendication 6, **caractérisé en ce que** les impulsions sont de forme triangulaire.

9. Dispositif selon la revendication 6, **caractérisé en ce que** l'amplificateur de mesure (13) supprime les tensions continues.

10. Dispositif selon la revendication 6, **caractérisé en ce que** l'amplificateur de mesure (13) supprime les fréquences perturbatrices.

11. Dispositif selon la revendication 6, **caractérisé en ce que** l'amplificateur de mesure (13) opère en synchronisme avec le système stimulateur (6).

12. Dispositif selon la revendication 1, **caractérisé en ce que** la première électrode (11, 42) est agencée à proximité du composant (2, 21, 30) de façon à pouvoir être déplacée.

13. Dispositif selon la revendication 1, **caractérisé en ce que** la première électrode est conçue en forme de matrice d'électrodes matricielles (61) séparées et pouvant être connectées à volonté à l'amplificateur de mesure (13).

14. Dispositif selon la revendication 13, **caractérisé en ce que** les électrodes matricielles se présentent sous forme d'un agencement croisé d'électrodes de lignes (71a - 71c) et d'électrodes de colonnes (72a - 72c), l'une quelconque des électrodes de ligne et l'une quelconque des électrodes de colonne étant connectées simultanément.
